# EUROPEAN PATENT APPLICATION

(11) **EP 4 641 423 A1**
(43) Date of publication of application: **29.10.2025**
(21) Application number: 23910118.1
(22) Date of filing: 13.12.2023
(51) Int. Cl.: G06F 30/10, G06T 11/20

(54) **LAYOUT DIAGRAM GENERATION METHOD, APPARATUS AND SYSTEM FOR PHOTOVOLTAIC POWER GENERATION SYSTEM, AND STORAGE MEDIUM**

(30) Priority: 30.12.2022 CN 202211725542
(71) Applicant: Hoymiles Power Electronics Inc., Hangzhou, Zhejiang 310015 (CN)
(72) Inventor: YU, Hongbin, Hangzhou, Zhejiang 310015 (CN); LI, Jun, Hangzhou, Zhejiang 310015 (CN); WANG, Jingming, Hangzhou, Zhejiang 310015 (CN); ZHAO, Yi, Hangzhou, Zhejiang 310015 (CN); YANG, Bo, Hangzhou, Zhejiang 310015 (CN)
(74) Representative: Meyer-Dulheuer MD Legal Patentanwälte PartG mbB
(86) International application number: PCT/CN2023/138286
(87) International publication number: WO 2024/140188

(57) **Abstract**

A layout diagram generation method, an apparatus, and a system for a photovoltaic power generation system, and a storage medium are provided. The method includes: acquiring device information and first electrical location information of each of the plurality of photovoltaic devices, and acquiring physical location information of the at least one photovoltaic module and second electrical location information of a photovoltaic device connected to the at least one photovoltaic module. Generating a layout diagram of the photovoltaic power generation system based on the first electrical location information, the second electrical location information, the device information, and the physical location information.

## Description

### CROSS-REFERENCE TO RELATED APPLICATION

This application claims priority to Chinese patent application No. 202211725542.6, filed on December 30, 2022, and titled "LAYOUT DIAGRAM GENERATION METHOD, APPARATUS AND SYSTEM FOR PHOTOVOLTAIC POWER GENERATION SYSTEM, AND STORAGE MEDIUM". The content of the above identified application is hereby incorporated herein in its entirety by reference.

### TECHNICAL FIELD

The present invention generally relates to the field of photovoltaic power generation technology, and in particular, to a layout diagram generation method, an apparatus, and a system for a photovoltaic power generation system, and a storage medium.

### BACKGROUND

A photovoltaic power generation system of a photovoltaic power station includes a plurality of photovoltaic modules and a plurality of photovoltaic device groups, and each of the photovoltaic modules includes a plurality of photovoltaic cell strings, and each of the photovoltaic device groups includes a plurality of photovoltaic devices, each of the plurality of photovoltaic devices is connected to at least one photovoltaic cell string. In an operation and maintenance process of the photovoltaic power station, it is inevitable that faults will occur. When faults occur in the photovoltaic power generation system, technicians can find a physical location of a photovoltaic module bound to a product sequence number in a layout diagram of the photovoltaic power generation system through the product sequence number of a photovoltaic device in a report of the photovoltaic power generation system, so that technicians can find the photovoltaic device and photovoltaic modules connected to the photovoltaic device for troubleshooting.

In the related art, generally, a corresponding tag code (such as a two-dimensional code, a bar code, etc.) is attached to each of the plurality of photovoltaic devices. In a mounting process of the photovoltaic power generation system, an assembly crewman tears off the tag code of each of the plurality of photovoltaic devices in sequence and attaches the tag code to a corresponding paper marked with the physical location of the photovoltaic module. After all photovoltaic modules are mounted, the technicians need to manually scan each tag code on the paper attached with the tag code one by one to obtain the product sequence number of the photovoltaic device stored in each tag code, and also need to manually bind each product sequence number with the corresponding photovoltaic module to generate a layout diagram. Obviously, a method in the related art is too complicated, inefficient, and prone to errors.

### SUMMARY

According to various embodiments of the present invention, a layout diagram generation method, an apparatus, and a system for a photovoltaic power generation system, and a storage medium are provided.

In a first aspect, a layout diagram generation method for a photovoltaic power generation system is provided and applied to the photovoltaic power generation system. The photovoltaic power generation system includes at least one photovoltaic module and at least one photovoltaic device group. The at least one photovoltaic module includes a plurality of photovoltaic cell strings. The at least one photovoltaic device group includes a plurality of photovoltaic devices connected to at least one of the plurality of photovoltaic cell strings respectively, and the method includes: acquiring device information and first electrical location information of each of the plurality of photovoltaic devices, and the first electrical location information including a group number of a photovoltaic device group to which a corresponding photovoltaic device belongs and location ranking information of the photovoltaic device in the photovoltaic device group to which the photovoltaic device belongs; acquiring physical location information of the at least one photovoltaic module and second electrical location information of a photovoltaic device connected to the at least one photovoltaic module, the second electrical location information including a group number of a photovoltaic device group to which the photovoltaic device belongs and location ranking information of the photovoltaic device in the photovoltaic device group to which the photovoltaic device belongs; and generating a layout diagram of the photovoltaic power generation system based on the first electrical location information, the second electrical location information, the device information, and the physical location information.

In an embodiment, generating the layout diagram of the photovoltaic power generation system based on the first electrical location information, the second electrical location information, the device information, and the physical location information further includes: acquiring a mapping relationship between device information of each of the plurality of photovoltaic devices and physical location information of the at least one photovoltaic module based on correspondence between the first electrical location information and the second electrical location information, and generating the layout diagram of the photovoltaic power generation system based on the mapping relationship, the device information, and the physical location information.

In an embodiment, generating the layout diagram of the photovoltaic power generation system based on the mapping relationship, the device information, and the physical location information further includes: determining, in a layout diagram template based on the mapping relationship and the physical location information, at least one virtual unit corresponding to each of the plurality of photovoltaic devices, one virtual unit corresponding to one photovoltaic module; and binding the device information of each of the plurality of photovoltaic devices to the at least one virtual unit corresponding to the corresponding photovoltaic device in the layout diagram template, to generate the layout diagram of the photovoltaic power generation system.

In an embodiment, generating the layout diagram of the photovoltaic power generation system based on the mapping relationship, the device information, and the physical location information further includes: determining, in a layout diagram template based on the mapping relationship and the physical location information, at least one virtual unit corresponding to each of the plurality of photovoltaic devices, one virtual unit corresponds to one photovoltaic module; and binding the device information and the second electrical location information of each of the plurality of photovoltaic devices to the at least one virtual unit corresponding to the corresponding photovoltaic device in the layout diagram template, to generate the layout diagram of the photovoltaic power generation system.

In an embodiment, while acquiring physical location information of the at least one photovoltaic module and second electrical location information of the photovoltaic device connected to the at least one photovoltaic module, the method includes further acquiring connection information of the at least one photovoltaic module, the connection information includes connection information between the at least one photovoltaic module and a port of a photovoltaic device corresponding to the photovoltaic module; and generating the layout diagram of the photovoltaic power generation system based on the first electrical location information, the second electrical location information, the device information, the physical location information, and the connection information.

In an embodiment, acquiring physical location information of the at least one photovoltaic module and second electrical location information of the photovoltaic device connected to the at least one photovoltaic module further includes: acquiring, based on a design drawing of the photovoltaic power generation system, physical location information of the at least one photovoltaic module and second electrical location information of the photovoltaic device connected to the at least one photovoltaic module.

In an embodiment, acquiring device information and first electrical location information of each of the plurality of photovoltaic devices further includes: acquiring, based on communication with a management module in the photovoltaic power generation system, device information and first electrical location information of each of the plurality of photovoltaic devices, and the management module obtaining device information and first electrical location information of each of the plurality of photovoltaic devices based on communication with each of the plurality of photovoltaic devices.

In an embodiment, the management module obtaining device information and first electrical location information of each of the plurality of photovoltaic devices based on communication with each of the plurality of photovoltaic devices further includes: grouping the plurality of photovoltaic devices based on communication with each of the plurality of photovoltaic devices by a grouping method, to determine the at least one photovoltaic device group; determining location ranking information of each of the plurality of photovoltaic devices in the at least one photovoltaic device group based on communication with the at least one photovoltaic device group by a ranking method; determining, based on the communication with the at least one photovoltaic device group, the group number of the photovoltaic device group to which the corresponding photovoltaic device belongs according to a collected electrical characteristic of an input port of a convergence device connected to the at least one photovoltaic device group.

In a second aspect, a layout diagram generation apparatus is provided in an embodiment of the present invention, which is applied to a photovoltaic power generation system. The photovoltaic power generation system includes at least one photovoltaic module and at least one photovoltaic device group, the at least one photovoltaic module includes a plurality of photovoltaic cell strings, the at least one photovoltaic device group includes a plurality of photovoltaic devices connected to at least one of the plurality of photovoltaic cell strings respectively, the apparatus includes a memory and a processor, the memory stores a computer program, and the processor is configured to execute the computer program to perform the method in the first aspect.

In a third aspect, a layout diagram generation system is provided in an embodiment of the present invention. The layout diagram generation system includes at least one photovoltaic module, at least one photovoltaic device group, and the layout diagram generation apparatus of the second aspect. The at least one photovoltaic module includes a plurality of photovoltaic cell strings, and the at least one photovoltaic device group includes a plurality of photovoltaic devices connected to at least one of the plurality of photovoltaic cell strings respectively.

In a fourth aspect, a computer-readable storage medium is provided in an embodiment of the present invention. The computer-readable storage medium stores a computer program, and the computer program is executed by a processor to perform the method in the first aspect.

Details of one or more embodiments of the present invention are proposed in the following accompanying drawings and descriptions, so that other features, objects, and advantages of the present invention are more easily understood.

### BRIEF DESCRIPTION OF THE DRAWINGS

In order to more clearly describe technical solutions in the embodiments or the related art, the following briefly describes the accompanying drawings required for describing the embodiments or the conventional technologies. Apparently, the accompanying drawings in the following description show merely the embodiments of the present invention, and one skilled in the art may still derive other drawings from the disclosed accompanying drawings without creative efforts.
FIG. 1 is a schematic diagram of a photovoltaic power generation system in a first embodiment.
FIG. 2 is a schematic diagram of a photovoltaic power generation system in a second embodiment.
FIG. 3 is a schematic diagram of a photovoltaic power generation system in a third embodiment.
FIG. 4 is a schematic diagram of a photovoltaic power generation system in a fourth embodiment.
FIG. 5 is a schematic diagram of a photovoltaic power generation system in a fifth embodiment.
FIG. 6 is a flowchart of a layout diagram generation method in an embodiment.
FIG. 7 is a flowchart of a layout diagram generation method in an embodiment.
FIG. 8 is a specific flowchart of a layout diagram generation method in an embodiment.
FIG. 9 is a schematic diagram of a physical layout of a photovoltaic module in a photovoltaic power generation system in a second embodiment.
FIG. 10 is a schematic diagram of a physical layout of a photovoltaic module in a photovoltaic power generation system in a third embodiment.
FIG. 11 is a schematic diagram of a physical layout of a photovoltaic module in a photovoltaic power generation system in a fourth embodiment.
FIG. 12 is a schematic diagram of a physical layout of a photovoltaic module in a photovoltaic power generation system in a fifth embodiment.
FIG. 13 is a specific flowchart of a layout diagram generation method in another embodiment.
FIG. 14 is a flowchart of a method for acquiring a first electrical location information in an embodiment.
FIG. 15 is a flowchart of a grouping method in an embodiment.
FIG. 16 is a flowchart of a grouping method in another embodiment.
FIG. 17 is a flowchart of a sorting method in an embodiment.
FIG. 18 is a flowchart of a method for determining a group number in an embodiment.
FIG. 19 is a schematic diagram of a layout diagram generation apparatus in an embodiment.

### DETAILED DESCRIPTION OF THE EMBODIMENT

In order to more clearly illustrate technical solutions of embodiments of the present invention, a brief introduction will be given below to the accompanying drawings required for the description of the embodiments. It is obvious that the drawings described below are only some examples or embodiments of the present invention. For one skilled in the art, the present invention may be applied to other similar scenarios based on these drawings without creative labor. Unless it is obvious from the language environment or otherwise specified, the same label in the figure represents the same structure or operation.

As shown in the present invention and claims, unless the context clearly indicates an exception, words such as "one", "a", "a kind of", and/or "the" do not specifically refer to singular, but may also include plural. Generally speaking, terms "include" and "contain" only indicate steps and elements that have been clearly identified are included, and these steps and elements do not constitute an exclusive list. Methods or devices may also contain other steps or elements.

Although various references are made to certain modules in a system according to embodiments of the present invention, any number of different modules may be used and run on computing devices and/or processors. The modules are only illustrative, and different aspects of the system and method may use different modules.

When a unit or a module is described as "connecting" or "coupling" with other units, modules, or blocks, it may refer to direct connection or coupling, or communication with other units, modules, or blocks, or there may be intermediate units, modules, or blocks, unless otherwise specified in the context. The term "and/or" used in this article may include any and all combinations of one or more related listed items.

A layout diagram generation method for a photovoltaic power generation system is provided in the present invention and applied to the photovoltaic power generation system. The photovoltaic power generation system includes at least one photovoltaic module and at least one photovoltaic device group. The at least one photovoltaic module includes a plurality of photovoltaic cell strings. The at least one photovoltaic device group includes a plurality of photovoltaic devices connected to at least one of the plurality of photovoltaic cell strings respectively.

Each of the at least one photovoltaic module includes a plurality of photovoltaic cell strings. In some embodiments, the plurality of photovoltaic cell strings can be connected to photovoltaic devices, respectively. In other embodiments, the plurality of photovoltaic cell strings can be connected in series or in parallel as a module and connected to the plurality of photovoltaic devices.

In some embodiments, the photovoltaic power generation system may further include at least one convergence device connected with the at least one photovoltaic device group. The convergence device is configured to ensure an orderly connection of photovoltaic device groups and realize a convergence function.

The convergence device may include but is not limited to an AC (Alternating Current) convergence box, a DC (Direct Current) convergence box, an inverter, etc.

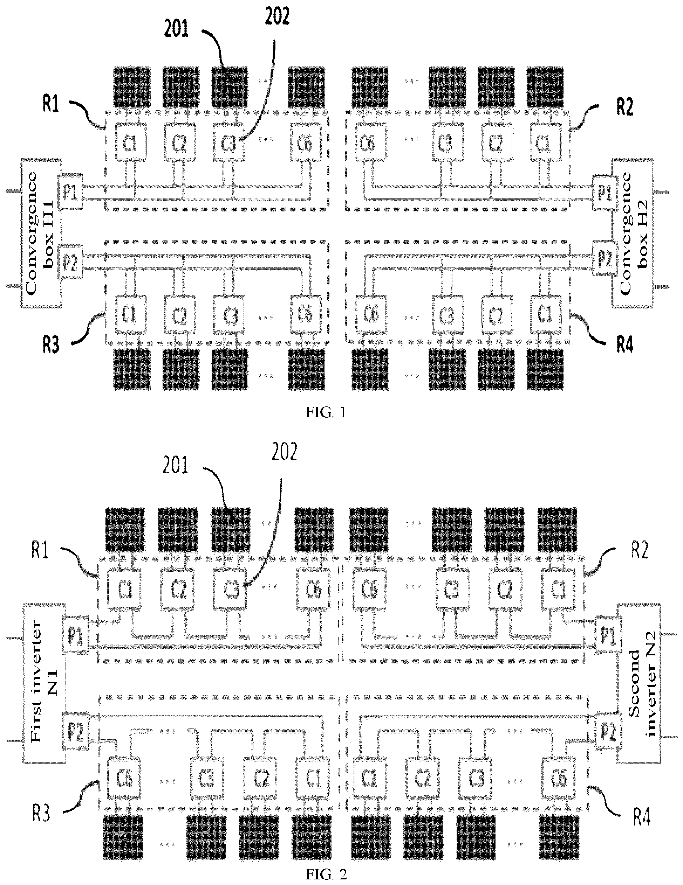

FIG. 1 is a schematic diagram of a photovoltaic power generation system in a first embodiment. The photovoltaic power generation system may include a management module (not shown in the figure), a first convergence box H1, a second convergence box H2, a plurality of photovoltaic modules 201, and a plurality of photovoltaic device groups R1, R2, R3 and R4 connected to the first convergence box H1 and the second convergence box H2. Each of the plurality of photovoltaic device groups may include a plurality of photovoltaic devices 202 connected to at least one of the plurality of photovoltaic modules 201, respectively.

In some embodiments, the plurality of photovoltaic modules 201 may include photovoltaic panels. Alternatively, the plurality of photovoltaic devices 202 can be a micro inverter, which is configured to equip each of the plurality of photovoltaic modules 201 separately with an inverter module with an AC-DC conversion function and a maximum power point tracking function, so as to directly convert an electric energy generated by the plurality of photovoltaic modules into AC electric energy for AC load or transmission to a power grid.

The plurality of photovoltaic modules 201 are configured to convert a radiant energy of sunlight into a direct current, the plurality of photovoltaic devices 202 are configured to adjust an output state of the plurality of photovoltaic modules 201 and directly convert an electric energy generated by the plurality of photovoltaic modules 201 into alternating current, and the convergence box may be a wiring device to ensure orderly connection and convergence functions of the photovoltaic device group. A plurality of photovoltaic devices in the same photovoltaic device group may be connected in parallel, and the plurality of photovoltaic device groups may be connected to a plurality of input ports of the convergence box. The management module may communicate with the plurality of photovoltaic devices 202. It may be understood that in other embodiments, the plurality of photovoltaic devices 202 in a photovoltaic device group may also be connected in series.

FIG. 2 is a schematic diagram of a photovoltaic power generation system in a second embodiment. The photovoltaic power generation system may include a management module (not shown in the figure), a first inverter N1, a second inverter N2, a plurality of photovoltaic devices 201, and a plurality of photovoltaic device groups R1, R2, R3 and R4 connected to the first inverter N1 and the second inverter N2. Each of the plurality of photovoltaic device groups may include a plurality of photovoltaic devices 202 connected to at least one of the plurality of photovoltaic devices 201, respectively.

In some embodiments, the plurality of photovoltaic modules 201 may include photovoltaic panels. Alternatively, the plurality of photovoltaic devices 202 may have one or more functions as follows: adjusting an output power of the plurality of photovoltaic modules 201 (at this moment, the plurality of photovoltaic devices may also be called optimizers), controlling the plurality of photovoltaic modules 201 to start or stop an output (at this moment, the plurality of photovoltaic devices may also be called shutdown devices), and monitoring an output status of the plurality of photovoltaic modules 201 (at this moment, the plurality of photovoltaic devices may also be called monitors). For example, the plurality of photovoltaic devices 202 may make the output power of the plurality of photovoltaic modules 201 reach a maximum power by adjusting a voltage amplitude and a current amplitude of the direct current output by the plurality of photovoltaic modules 201, so as to improve utilization rate of the plurality of photovoltaic modules 201.

The plurality of photovoltaic modules 201 are configured to convert a radiant energy of sunlight into a direct current, the plurality of photovoltaic devices 202 are configured to adjust an output state of the plurality of photovoltaic modules 201, and the inverter is configured to convert a direct current provided by the plurality of photovoltaic modules 201 into an alternating current and output the alternating current. The plurality of photovoltaic devices in the same photovoltaic device group may be connected in series, and the plurality of photovoltaic device groups may be connected to a plurality of DC input ports of the inverter, respectively. The management module may communicate with the plurality of photovoltaic devices 202.

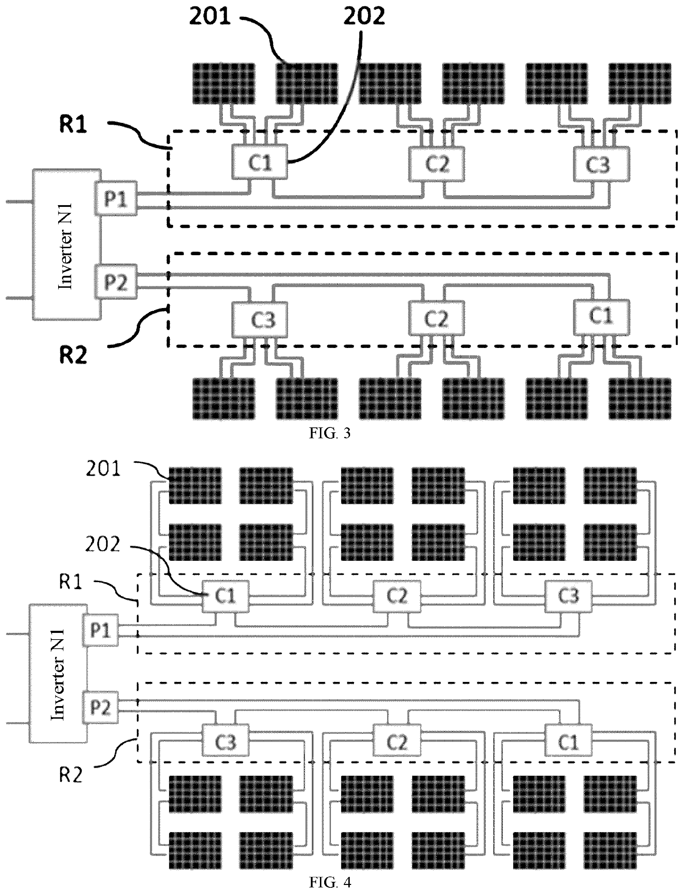

FIG. 3 is a schematic diagram of a photovoltaic power generation system in a third embodiment. The photovoltaic power generation system may show an inverter N1 and photovoltaic device groups R1 and R2 connected to an input port P1 and an input port P2 of the inverter respectively, and each of the photovoltaic device groups may include a plurality of photovoltaic devices 202 connected to two of the plurality of photovoltaic modules 201 respectively. Referring to FIG. 3, two of the plurality of photovoltaic modules 201 may be connected to two ports of one of the plurality of photovoltaic devices 202 respectively.

It can be understood that each of the plurality of photovoltaic devices can have three or more ports to connect three or more photovoltaic modules.

FIG. 4 is a schematic diagram of a photovoltaic power generation system in a fourth embodiment. The photovoltaic power generation system may show an inverter N1 and photovoltaic device groups R1 and R2 connected to an input port P1 and an input port P2 of the inverter respectively, and each of the photovoltaic device groups may include a plurality of photovoltaic devices 202 connected to four of the plurality of photovoltaic modules 201 respectively. Referring to FIG. 4, every two of the plurality of photovoltaic modules 201 may be connected to one port of a photovoltaic device 202, and two of the plurality of photovoltaic modules 201 connected to one port may be connected in series. It can be understood that in other embodiments, two or more of the plurality of photovoltaic modules connected to each port of the photovoltaic device may also be connected in parallel.

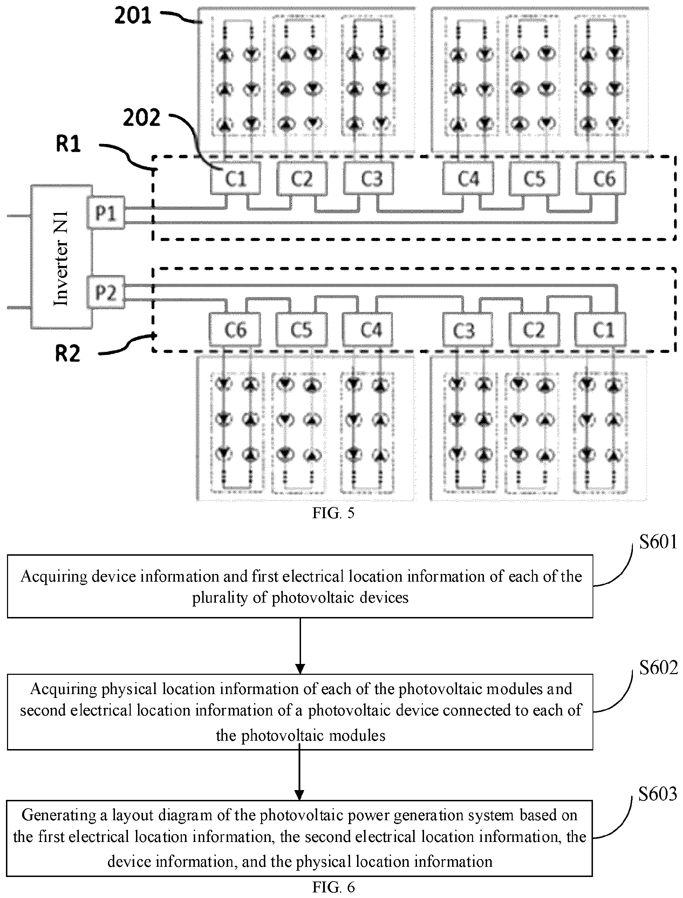

FIG. 5 is a schematic diagram of a photovoltaic power generation system in a fifth embodiment. The photovoltaic power generation system may show an inverter N1 and photovoltaic device groups R1 and R2 connected to an input port P1 and an input port P2 of the inverter respectively, and each of the photovoltaic device groups may include a plurality of photovoltaic devices 202 connected to photovoltaic cell strings of the plurality of photovoltaic modules 201 respectively. Referring to FIG. 5, each of the plurality of photovoltaic modules 201 may include three photovoltaic cell strings, each of which is connected to one of the plurality of photovoltaic devices 202, and the plurality of photovoltaic devices in a photovoltaic device group may be connected in series. It can be understood that in other embodiments, the quantity of photovoltaic cell strings included in each photovoltaic module may also be two or more. One of the plurality of photovoltaic devices may also be connected to two or more photovoltaic cell strings. The plurality of photovoltaic devices in a photovoltaic device group may also be connected in parallel.

Referring to FIG. 1 to FIG. 5, each of the plurality of photovoltaic devices may have a corresponding electrical location information. The electrical location information of each of the plurality of photovoltaic devices may at least include a group number of a photovoltaic device group to which a corresponding photovoltaic device belongs and location ranking information of the photovoltaic device in the photovoltaic device group to which the photovoltaic device belongs. Each photovoltaic device group may have a group number, such as R1, R2, R3, R4, etc. Furthermore, the group number of the photovoltaic device group may be represented by the number of the inverter/ convergence box connected to the photovoltaic device group and the number of an input port of the inverter/convergence box, such as N1-P1, N1-P2, etc. The location ranking information of each photovoltaic device in the photovoltaic device group to which the photovoltaic device belongs may be as follows. For example, referring to FIG 1, the photovoltaic device in the photovoltaic device group may be defined as C1, C2, C3, ..., C6, etc. from the closest to the port of the convergence device to the farthest from the port of the convergence device. Alternatively, referring to FIG 2 to FIG 5, the photovoltaic device in the photovoltaic device group may be defined as C1, C2, C3, ..., C6, etc. from a positive electrode to a negative electrode of the photovoltaic device group.

Each photovoltaic device may have corresponding device information. The device information of the photovoltaic device may be unique identification information such as a product sequence number of the photovoltaic device. A carrier of device information, namely device identification, may be a two-dimensional code set on photovoltaic device. The device information of the photovoltaic device may be obtained by identifying the two-dimensional code. It can be understood that the device identification is not limited to the two-dimensional code, but also can be other forms of an information carrier or a tag code such as a one-dimensional code.

Each photovoltaic module may have corresponding physical location information. The plurality of photovoltaic modules in the photovoltaic power generation system may form a photovoltaic array, and the physical location information of the photovoltaic modules may include row and column numbers of the photovoltaic modules to indicate row and column positions of the photovoltaic modules in the photovoltaic array. For example, 1-1 may indicate that a photovoltaic module is located in a first row and a first column. In a case of multiple photovoltaic arrays in the photovoltaic power generation system, the physical location information of photovoltaic modules may also include an orientation information of the photovoltaic array to which the photovoltaic modules belong. For example, ES-1-1 may indicate that a photovoltaic module is located in the first row and the first column in the photovoltaic array in the southeast, and NS-1-1 may indicate that a photovoltaic module is located in the first row and the first column in the photovoltaic array in the southwest. In other embodiments, the physical location information of the photovoltaic module may also include information such as azimuth, inclination and orientation of the photovoltaic module.

Generally, after actual mounting and deployment of the photovoltaic power generation system, it is necessary to store product sequence numbers of all photovoltaic devices in the photovoltaic power generation system and the physical location information of the corresponding photovoltaic modules in the layout diagram, which is convenient for rapid and accurate management work such as maintenance and replacement. In the related art, in the mounting process of the photovoltaic power generation system, the assembly crewman sequentially tears off the tag code of each of the plurality of photovoltaic devices in sequence and attaches the tag code to the corresponding paper marked with the physical location of the photovoltaic modules. After all photovoltaic modules and photovoltaic devices are mounted, the technicians need to manually scan each tag code on the paper attached with the tag code one by one to obtain the product sequence numbers of the photovoltaic devices stored in each tag code, and also need to manually bind each product sequence number with the physical location information of the corresponding photovoltaic module. Obviously, the method in the related art is too complicated, inefficient, and prone to errors.

In order to solve this problem, the present invention provides a layout diagram generation method for a photovoltaic power generation system. Referring to FIG 6, the method includes the following step 601 to step 603.

Step 601 includes acquiring device information and first electrical location information of each of the plurality of photovoltaic devices.

The first electrical location information includes a group number of a photovoltaic device group to which a corresponding photovoltaic device belongs and location ranking information of the photovoltaic device in the photovoltaic device group to which the photovoltaic device belongs.

The device information may be the product sequence number of the corresponding photovoltaic device.

The device information and the first electrical location information may be acquired automatically by the management module or by manually scanning the tag code on the photovoltaic device.

Step 602 includes acquiring physical location information of each of the photovoltaic modules and second electrical location information of a photovoltaic device connected to each of the photovoltaic modules.

The second electrical location information includes a group number of a photovoltaic device group to which the photovoltaic device belongs and location ranking information of the photovoltaic device in the photovoltaic device group to which the photovoltaic device belongs.

The physical location information of each of the photovoltaic modules may include the row and column number of each of the photovoltaic modules.

The physical location information of each of the photovoltaic modules and the second electrical location information of the photovoltaic device connected to the corresponding photovoltaic module may be acquired through a design drawing of the photovoltaic power generation system.

Exemplarily, the design drawing of the photovoltaic power generation system may be a computer aided design (CAD) drawing, and the design drawing may include the physical location information of each of the photovoltaic modules and the second electrical location information of the photovoltaic device. Generally, the CAD drawing may be reserved after construction of a photovoltaic power station and may be obtained directly. In an embodiment, the relative position of each of the photovoltaic modules may be drawn in the CAD drawing, a rectangular frame may represent a photovoltaic module, and a position of the rectangular frame in the CAD drawing may represent the physical location information of the photovoltaic module. For example, the physical location information of the photovoltaic module corresponding to the rectangular frame in the first row and the first column may be 1-1. Moreover, the corresponding second electrical location information may be displayed on each rectangular frame. Exemplarily, the second electrical location information may be labeled according to circuit logic. In some embodiments, the second electrical location information may be numbered when the photovoltaic power station is designed, and this number may be marked in the design drawing, so it is only necessary to identify the number. For example, the number N1-P1-C1 may represent that the photovoltaic module located in the first row and the first column is located in the first position from the positive electrode to the negative electrode in the photovoltaic device group N1-P1, which is connected to an input port P1 of an inverter N1. Therefore, the physical location information of each of the photovoltaic modules and the second electrical location information of the photovoltaic device connected to the corresponding photovoltaic module may be acquired based on the design drawing.

In other embodiments, the design drawing of the photovoltaic power generation system may be generated by professional design software, which may automatically lay out the layout based on station building conditions of the photovoltaic power generation system, and the design drawing generated based on the professional design software may directly derive the physical location information of each of the photovoltaic modules and the second electrical location information of the photovoltaic device connected to the corresponding photovoltaic module.

Step 603 includes generating a layout diagram of the photovoltaic power generation system based on the first electrical location information, the second electrical location information, the device information, and the physical location information.

Each virtual unit in the layout diagram may include or implies the physical location information of the corresponding photovoltaic module and the device information of the photovoltaic device connected to the corresponding photovoltaic module.

For example, the physical location information of the photovoltaic module may be represented by characters or by location information of the virtual unit in the layout.

For example, the physical location information of the photovoltaic module corresponding to the virtual unit in the first row and the first column may be 1-1, so there is no need to represent the physical location information of the photovoltaic module with characters on the virtual unit.

It can be understood that the device information of the photovoltaic device corresponding to the physical location information of each of the photovoltaic modules may be determined based on the first electrical location information and the second electrical location information, and then the layout diagram of the photovoltaic power generation system may be generated based on the device information of the photovoltaic devices and the physical location information of the photovoltaic modules.

Based on step 601 to step 603, the device information and the first electrical location information of each of the photovoltaic devices are acquired, the physical location information of each of the photovoltaic modules and the second electrical location information of the photovoltaic device connected to the corresponding photovoltaic module are acquired, and the layout diagram of the photovoltaic power generation system is generated based on the first electrical location information, the second electrical location information, the device information, and the physical location information. **In** this embodiment, the layout diagram of the photovoltaic power generation system is generated based on the electrical location information of the photovoltaic device, the device information of the photovoltaic device, and the physical location information of the photovoltaic module, thereby improving accuracy of generating the layout diagram, and mounting efficiency and operation and maintenance efficiency of the photovoltaic power generation system.

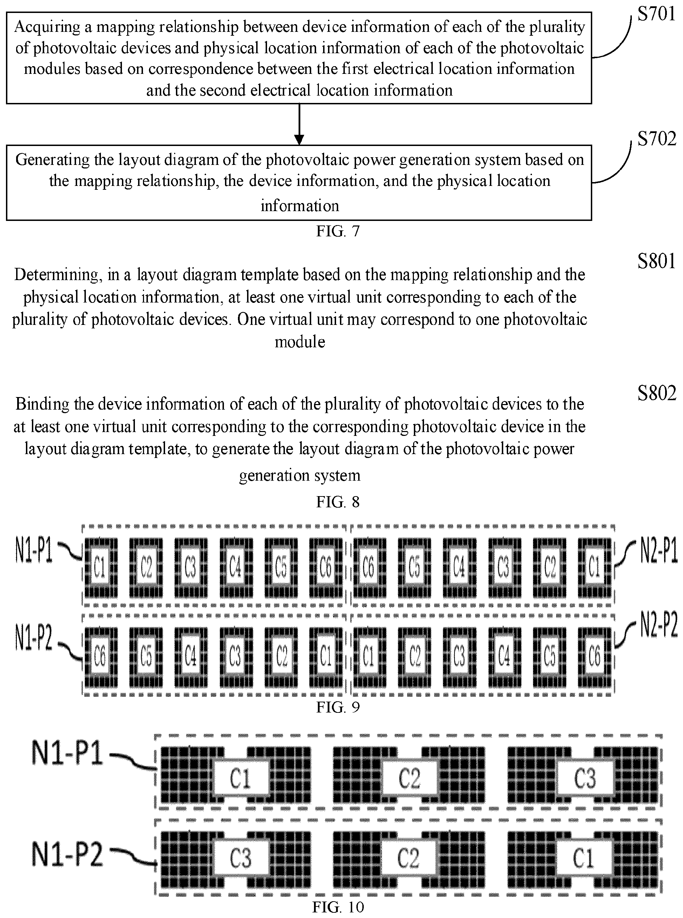

**In** an embodiment, referring to FIG. 7, generating the layout diagram of the photovoltaic power generation system based on the first electrical location information, the second electrical location information, the device information and the physical location information may further include the following step 701 and step 702.

Step 701 may include acquiring a mapping relationship between device information of each of the plurality of photovoltaic devices and physical location information of each of the photovoltaic modules based on correspondence between the first electrical location information and the second electrical location information.

Step 702may include generating the layout diagram of the photovoltaic power generation system based on the mapping relationship, the device information, and the physical location information.

The mapping relationship may include a connection relationship between each of the photovoltaic devices and each of the photovoltaic modules. According to the mapping relationship, the device information of the photovoltaic device connected to each of the photovoltaic modules may be determined, and the physical location information of each of the photovoltaic modules may be associated with the virtual unit in the layout diagram, so that the layout diagram of the photovoltaic power generation system may be generated.

In an embodiment, referring to FIG. 8, generating the layout diagram of the photovoltaic power generation system based on the mapping relationship, the device information, and the physical location information may further include the following step 801 and step 802.

Step 801 may include determining, in a layout diagram template based on the mapping relationship and the physical location information, at least one virtual unit corresponding to each of the plurality of photovoltaic devices. One virtual unit may correspond to one photovoltaic module.

Step 802 may include binding the device information of each of the plurality of photovoltaic devices to the at least one virtual unit corresponding to the corresponding photovoltaic device in the layout diagram template, to generate the layout diagram of the photovoltaic power generation system.

The layout diagram template may be drawn with a table, the whole table may represent a photovoltaic array, each cell of the table may represent a virtual unit, and a virtual unit may correspond to a photovoltaic module of the photovoltaic array. According to the physical location information of each of the photovoltaic modules acquired based on the design drawing, the layout diagram template may be generated.

Each row of the table in the layout diagram template may have a number, for example, 1, 2, 3 ..., and each column of the table in the layout diagram template may also have a number, for example, 1, 2, 3 ..., then the physical position of any cell in the table may be represented by the number of the row and the column. For example, the physical location information of the cell in the first row and the first column in the layout diagram template may be represented as 1-1. Then the virtual unit with the physical location information of 1-1 may represent a photovoltaic module located in the first row and the first column of the photovoltaic array.

According to the mapping relationship, i.e., the connection relationship between each of the photovoltaic devices and each of the photovoltaic modules in the photovoltaic power generation system, the photovoltaic device corresponding to each cell in the layout template may be determined, and the device information of each of the photovoltaic devices may be associated. The layout diagram of the photovoltaic power generation system may be generated by binding the device information of each of the photovoltaic devices with at least one corresponding virtual unit in the layout diagram template.

Referring to FIG. 1 and FIG. 2, in an exemplary embodiment, each of the photovoltaic devices may be connected to a photovoltaic module. The device information and the first electrical location information of each of the photovoltaic devices may be stored in a result list, referring to Table 1, the device information and the corresponding first electrical location information may be stored in the same row of the result list. The first electrical location information may at least include the group number of the photovoltaic device group to which the photovoltaic device belongs and the location ranking of the photovoltaic device in the photovoltaic device group to which the photovoltaic device belongs. Table 1 may take the photovoltaic device group connected to the inverter shown in FIG. 2 as an example, and the group number of the photovoltaic device group may be represented by an inverter number and an input port number of the inverter. It can be understood that an information list similar to that in Table 1 may also be obtained in the embodiment where the photovoltaic device groups are connected to a convergence box referring to FIG. 1.

**Table 1**

| The device information of the photovoltaic device | The first electrical location information of the photovoltaic device |
|---|---|
| XXXXXX01 | N1-P1-C1 |
| XXXXXX02 | N1-P1-C2 |
| XXXXXX03 | N1-P1-C3 |
| XXXXXX04 | N1-P1-C4 |
| XXXXXX05 | N1-P1-C5 |
| XXXXXX06 | N1-P1-C6 |
| XXXXXX07 | N2-P1-C6 |
| XXXXXX08 | N2-P1-C5 |
| XXXXXX09 | N2-P1-C4 |
| XXXXXX10 | N2-P1-C3 |
| XXXXXX11 | N2-P1-C2 |
| XXXXXX12 | N2-P1-C1 |
| XXXXXX13 | N1-P2-C6 |
| XXXXXX14 | N1-P2-C5 |
| XXXXXX15 | N1-P2-C4 |
| XXXXXX16 | N1-P2-C3 |
| XXXXXX17 | N1-P2-C2 |
| XXXXXX18 | N1-P2-C1 |
| XXXXXX19 | N2-P2-C1 |
| XXXXXX20 | N2-P2-C2 |
| XXXXXX21 | N2-P2-C3 |
| XXXXXX22 | N2-P2-C4 |
| XXXXXX23 | N2-P2-C5 |
| XXXXXX24 | N2-P2-C6 |

The physical layout of the photovoltaic modules in FIG. 2 may refer to FIG. 9. Generally, the photovoltaic device may be mounted on the back of the corresponding photovoltaic module and electrically connected with the photovoltaic module. Referring to Table 2, the physical location information of each of the photovoltaic modules and the second electrical location information of the photovoltaic device connected to the corresponding photovoltaic module may be stored in an information list, and the physical location information and the second electrical location information may be stored in the same row of the information list, so that the physical location information may be associated with the second electrical location information. The second electrical location information may at least include the group number of the photovoltaic device group to which the photovoltaic device belongs and the location ranking information of the photovoltaic device in the photovoltaic device group to which the photovoltaic device belongs. Table 2 may take the photovoltaic device group connected to the inverter as an example, and the group number of the ohotovoltaic device group may be represented by the inverter number and the input port number of the inverter.

**Table 2**

| The physical location information of the photovoltaic module | The second electrical location information of the photovoltaic device |
|---|---|
| 1-1 | N1-P1-C1 |
| 1-2 | N1-P1-C2 |
| 1-3 | N1-P1-C3 |
| 1-4 | N1-P1-C4 |
| 1-5 | N1-P1-C5 |
| 1-6 | N1-P1-C6 |
| 1-7 | N2-P1-C6 |
| 1-8 | N2-P1-C5 |
| 1-9 | N2-P1-C4 |
| 1-10 | N2-P1-C3 |
| 1-11 | N2-P1-C2 |
| 1-12 | N2-P1-C1 |
| 2-1 | N1-P2-C6 |
| 2-2 | N1-P2-C5 |
| 2-3 | N1-P2-C4 |
| 2-4 | N1-P2-C3 |
| 2-5 | N1-P2-C2 |
| 2-6 | N1-P2-C1 |
| 2-7 | N2-P2-C1 |
| 2-8 | N2-P2-C2 |
| 2-9 | N2-P2-C3 |
| 2-10 | N2-P2-C4 |
| 2-11 | N2-P2-C5 |
| 2-12 | N2-P2-C6 |

Referring to Table 1 and Table 2, according to the correspondence between the first electrical location information and the second electrical location information, the mapping relationship between each of the photovoltaic devices and each of the photovoltaic modules may be determined. For example, the photovoltaic module with the physical location information 1-1 may correspond to the photovoltaic device N1-P1-C1. At least one virtual unit corresponding to each of the photovoltaic devices in the layout diagram template may be determined based on the mapping relationship. For example, there is a mapping relationship between the photovoltaic device N1-P1-C1 and the photovoltaic module with the physical location information 1-1, so it may be determined that the photovoltaic device N1-P1-C1 is corresponding to the cell 1-1 in the layout diagram template. The device information of the photovoltaic device N1-P1-C1 may be XXXXXXX 01. The device information of the photovoltaic device N1-P1-C1 may be filled into the cell 1-1 in the layout diagram template. The same binding operation for other photovoltaic devices may be performed to generate the layout diagram referring to Table 3.

**Table 3**

| | | | | | | | | | | | |
|---|---|---|---|---|---|---|---|---|---|---|---|
| XXXXXX 01 | XXXXXX 02 | XXXXXX 03 | XXXXXX 04 | XXXXXX 05 | XXXXXX 06 | XXXXXX 07 | XXXXXX 08 | XXXXXX 09 | XXXXXX 10 | XXXXXX 11 | XXXXXX 12 |
| XXXXXX 13 | XXXXXX 14 | XXXXXX 15 | XXXXXX 16 | XXXXXX 17 | XXXXXX 18 | XXXXXX 19 | XXXXXX 20 | XXXXXX 21 | XXXXXX 22 | XXXXXX 23 | XXXXXX 24 |

In an exemplary embodiment, each of the photovoltaic devices may be connected to more than one photovoltaic module, referring to FIG. 3, and it may take that each photovoltaic device is connected to two photovoltaic modules as an example. Referring to Table 4, the device information and the first electrical location information of each of the photovoltaic devices in the photovoltaic power generation system shown in FIG. 3 may be stored in a result list, and the device information and the corresponding first electrical location information may be stored in the same row of the result list.

**Table 4**

| The device information of the photovoltaic device | The first electrical location information of the photovoltaic device |
|---|---|
| XXXXXX01 | N1-P1-C1 |
| XXXXXX02 | N1-P1-C2 |
| XXXXXX03 | N1-P1-C3 |
| XXXXXX04 | N1-P2-C3 |
| XXXXXX05 | N1-P2-C2 |
| XXXXXX06 | N1-P2-C1 |

The physical layout of the photovoltaic modules in the photovoltaic power generation system shown in FIG 3 may refer to FIG 10. A photovoltaic device may be mounted on the back of a corresponding photovoltaic module and be electrically connected to all corresponding photovoltaic modules. The photovoltaic device may also be mounted in other positions such as a mounting guide rail and be electrically connected to all corresponding photovoltaic modules. Referring to Table 5, the physical location information of each of the photovoltaic modules and the second electrical location information of the photovoltaic device connected to the corresponding photovoltaic module may be stored in an information list, and the physical location information and the second electrical location information may be stored in the same row of the information list, so that the physical location information may be associated with the second electrical location information. The second electrical location information may include the group number of the photovoltaic device group to which the photovoltaic device belongs and the location ranking information of the photovoltaic device in the photovoltaic device group to which the photovoltaic device belongs.

In some embodiments, while acquiring the physical location information of each of the photovoltaic modules and the second electrical location information of the photovoltaic device connected to the corresponding photovoltaic module, connection information of each of the photovoltaic modules may also be acquired, which includes connection information of the photovoltaic module and a port of the corresponding photovoltaic device. Specifically, the connection information may include a port number of the connection between the photovoltaic module and the corresponding photovoltaic device. Exemplarily, the connection information C1-1 may indicate that the photovoltaic module is connected to a port 1 of the photovoltaic device C1, and the photovoltaic device C1 may be the first photovoltaic device in the positive pole of the photovoltaic device group to which the photovoltaic device C1 belongs. Referring to Table 5, the physical location information of the photovoltaic module, the second electrical location information of the photovoltaic device connected to the corresponding photovoltaic module, and the connection information may be stored in the same row of the information list, so that the information may be associated with each other.

**Table 5**

| The physical location information of the photovoltaic module | The second electrical location information of the photovoltaic device | The connection information |
|---|---|---|
| 1-1 | N1-P1-C1 | C1-1 |
| 1-2 | N1-P1-C1 | C1-2 |
| 1-3 | N1-P1-C2 | C2-1 |
| 1-4 | N1-P1-C2 | C2-2 |
| 1-5 | N1-P1-C3 | C3-1 |
| 1-6 | N1-P1-C3 | C3-2 |
| 2-1 | N1-P2-C3 | C3-1 |
| 2-2 | N1-P2-C3 | C3-2 |
| 2-3 | N1-P2-C2 | C2-1 |
| 2-4 | N1-P2-C2 | C2-2 |
| 2-5 | N1-P2-C1 | C1-1 |
| 2-6 | N1-P2-C1 | C1-2 |

According to Table 4 and Table 5, the first electrical location information and the second electrical location information which are consistent with each other may be found, thus establishing the mapping relationship between the photovoltaic devices and the photovoltaic modules. Therefore, the layout diagram referring to Table 6 may be generated by associating the device information of the photovoltaic devices with the physical location information of the photovoltaic modules.

**Table 6**

| | | | | | |
|---|---|---|---|---|---|
| XXXXXX 01 | XXXXXX 01 | XXXXXX 02 | XXXXXX 02 | XXXXXX 03 | XXXXXX 03 |
| XXXXXX 04 | XXXXXX 04 | XXXXXX 05 | XXXXXX 05 | XXXXXX 06 | XXXXXX 06 |

In some embodiments, the connection information of the photovoltaic modules may also be reflected in the layout diagram shown in Table 6. For example, it may be recorded in the cells of the first column and the second column of the first row in the form of "XXXXX01-1" and "XXXXX01-2", so as to indicate that the photovoltaic module corresponding to the cells are connected to a port 1 and a port 2 of the corresponding photovoltaic device, respectively.

In an exemplary embodiment, each input port of each of the photovoltaic devices may be connected with more than one photovoltaic module respectively, referring to FIG. 4, it may take each photovoltaic device with two input ports as an example, and each input port may be connected with two photovoltaic modules. Referring to Table 7, the device information and the first electrical location information of each of the photovoltaic devices in the photovoltaic power generation system shown in FIG. 4 may be stored in a result list, and the device information and the corresponding first electrical location information may be stored in the same row of the result list.

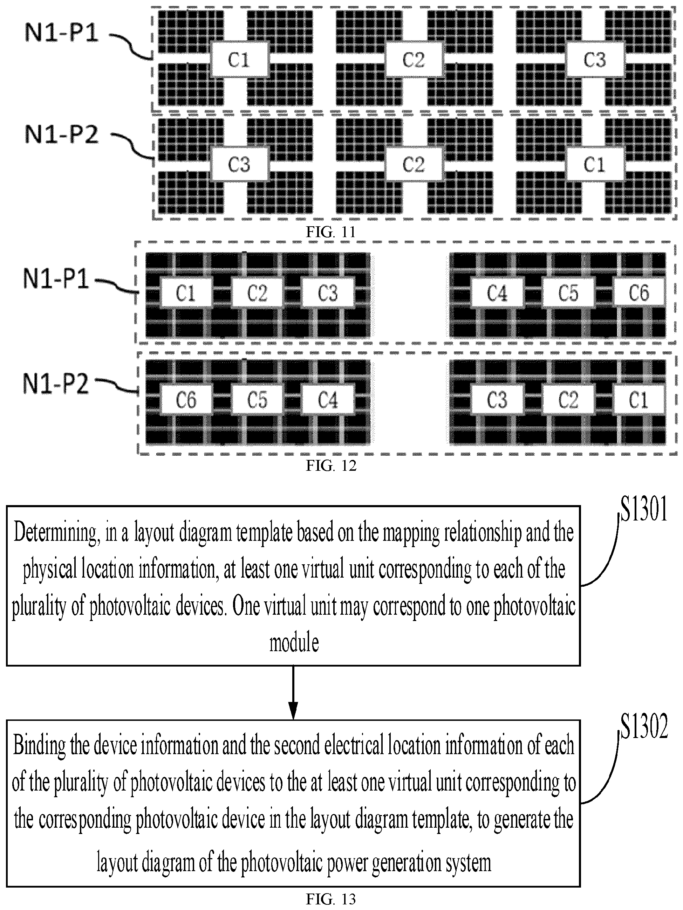

The physical layout of photovoltaic modules in the photovoltaic power generation system shown in FIG. 4 may refer to FIG. 11, the photovoltaic device may be mounted on the back of a corresponding photovoltaic module and be electrically connected to all corresponding photovoltaic modules. The photovoltaic device may also be mounted in other positions such as a mounting guide rail and be electrically connected to all corresponding photovoltaic modules. Referring to Table 8, the physical location information and the second electrical location information corresponding to each virtual unit in the layout diagram template may be stored in an information list, and the physical location information and the second electrical location information may be stored in the same row of the information list, so that the physical location information may be associated with the second electrical location information. The second electrical location information may include the group number of the photovoltaic device group to which the photovoltaic device belongs and the location ranking information of the photovoltaic device in the photovoltaic device group to which the photovoltaic device belongs.

**Table 7**

| The device information of the photovoltaic device | The first electrical location information of the photovoltaic device |
|---|---|
| XXXXXX01 | N1-P1-C1 |
| XXXXXX02 | N1-P1-C2 |
| XXXXXX03 | N1-P1-C3 |
| XXXXXX04 | N1-P2-C3 |
| XXXXXX05 | N1-P2-C2 |
| XXXXXX06 | N1-P2-C1 |

**Table 8**

| The physical location information of the photovoltaic module | The second electrical location information of the photovoltaic device | The connection information |
|---|---|---|
| 1-1 | N1-P1-C1 | C1-1-2 |
| 1-2 | N1-P1-C1 | C1-2-2 |
| 1-3 | N1-P1-C2 | C2-1-2 |
| 1-4 | N1-P1-C2 | C2-2-2 |
| 1-5 | N1-P1-C3 | C3-1-2 |
| 1-6 | N1-P1-C3 | C3-2-2 |
| 2-1 | N1-P1-C1 | C1-1-1 |
| 2-2 | N1-P1-C1 | C1-2-1 |
| 2-3 | N1-P1-C2 | C2-1-1 |
| 2-4 | N1-P1-C2 | C2-2-1 |
| 2-5 | N1-P1-C3 | C3-1-1 |
| 2-6 | N1-P1-C3 | C3-2-1 |
| 3-1 | N1-P2-C3 | C3-1-1 |
| 3-2 | N1-P2-C3 | C3-2-1 |
| 3-3 | N1-P2-C2 | C2-1-1 |
| 3-4 | N1-P2-C2 | C2-2-1 |
| 3-5 | N1-P2-C1 | C1-1-1 |
| 3-6 | N1-P2-C1 | C1-2-1 |
| 4-1 | N1-P2-C3 | C3-1-2 |
| 4-2 | N1-P2-C3 | C3-2-2 |
| 4-3 | N1-P2-C2 | C2-1-2 |
| 4-4 | N1-P2-C2 | C2-2-2 |
| 4-5 | N1-P2-C1 | C1-1-2 |
| 4-6 | N1-P2-C1 | C1-2-2 |

In some embodiments, while acquiring the physical location information of each of the photovoltaic modules and the second electrical location information of the photovoltaic device connected to the corresponding photovoltaic module, the connection information of each of the photovoltaic modules may also be acquired, which includes the connection information of the photovoltaic module and a port of the corresponding photovoltaic device. Specifically, the connection information may include the port number of the connection between the photovoltaic module and the corresponding photovoltaic device and ranking information at the port. Exemplarily, the connection information C1-1-1 may indicate that the photovoltaic module is connected to the port 1 of the photovoltaic device C1 and is the first photovoltaic module connected to the port 1, and the photovoltaic device C1 may be the first photovoltaic device in the positive pole of the photovoltaic device group to which the photovoltaic device C1 belongs. Referring to Table 8, the physical location information of the photovoltaic module, the second electrical location information of the photovoltaic device connected to the corresponding photovoltaic module, and the connection information may be stored in the same row of the information list, so that the information may be associated with each other.

According to Table 7 and Table 8, the first electrical location information and the second electrical location information which are consistent with each other may be found, thus establishing the mapping relationship between the photovoltaic devices and the photovoltaic modules. Therefore, the layout diagram of the photovoltaic power generation system referring to Table 9 may be generated by associating the device information of the photovoltaic devices with the physical location information of the photovoltaic modules.

**Table 9**

| | | | | | |
|---|---|---|---|---|---|
| XXXXXX 01 | XXXXXX 01 | XXXXXX 02 | XXXXXX 02 | XXXXXX 03 | XXXXXX 03 |
| XXXXXX 01 | XXXXXX 01 | XXXXXX 02 | XXXXXX 02 | XXXXXX 03 | XXXXXX 03 |
| XXXXXX 04 | XXXXXX 04 | XXXXXX 05 | XXXXXX 05 | XXXXXX 06 | XXXXXX 06 |
| XXXXXX 04 | XXXXXX 04 | XXXXXX 05 | XXXXXX 05 | XXXXXX 06 | XXXXXX 06 |

In some embodiments, the connection information of the photovoltaic modules may also be reflected in the layout diagram shown in Table 9. For example, it may be recorded in the cells of the first column of the first row and the first column of the second row in the form of "XXXXX01-1-2" and "XXXXX01-1-1", so as to indicate that the photovoltaic modules corresponding to the cells are the second photovoltaic module and first photovoltaic module connected to the port 1 of the corresponding photovoltaic device, respectively.

In an exemplary embodiment, each of the photovoltaic devices may be connected to a photovoltaic cell substring in a photovoltaic module, referring to FIG. 5, and an example may be given to illustrate that each photovoltaic module includes three photovoltaic cell substrings, and each photovoltaic cell substring is connected to a photovoltaic device. Referring to Table 10, the device information and the first electrical location information of each of the photovoltaic devices in the photovoltaic power generation system shown in FIG. 5 may be stored in a result list, and the device information and the corresponding first electrical location information may be stored in the same row of the result list.

**Table 10**

| The device information of the photovoltaic device | The first electrical location information of the photovoltaic device |
|---|---|
| XXXXXX01 | N1-P1-C1 |
| XXXXXX02 | N1-P1-C2 |
| XXXXXX03 | N1-P1-C3 |
| XXXXXX04 | N1-P1-C4 |
| XXXXXX05 | N1-P1-C5 |
| XXXXXX06 | N1-P1-C6 |
| XXXXXX07 | N1-P2-C6 |
| XXXXXX08 | N1-P2-C5 |
| XXXXXX09 | N1-P2-C4 |
| XXXXXX10 | N1-P2-C3 |
| XXXXXX11 | N1-P2-C2 |
| XXXXXX12 | N1-P2-C1 |

The physical layout of the photovoltaic modules in the photovoltaic power generation system shown in FIG. 5 may refer to FIG. 12, the photovoltaic device may be mounted on the back of a corresponding photovoltaic module and be electrically connected to all corresponding photovoltaic modules. The photovoltaic device may also be mounted in other positions such as a mounting guide rail and be electrically connected to all corresponding photovoltaic modules. Referring to Table 11, the physical location information and the second electrical location information corresponding to each virtual unit in the layout diagram template may be stored in an information list, and the physical location information and the second electrical location information may be stored in the same row of the information list, so that the physical location information may be associated with the second electrical location information. The second electrical location information may include the group number of the photovoltaic device group to which the photovoltaic device belongs and the location ranking information of the photovoltaic device in the photovoltaic device group to which the photovoltaic device belongs.

According to Table 10 and Table 11, the first electrical location information and the second electrical location information which are consistent with each other may be found, thus establishing the mapping relationship between the photovoltaic devices and the photovoltaic modules. Therefore, the layout diagram of the photovoltaic power generation system referring to Table 12 may be generated by associating the device information of the photovoltaic devices with the physical location information of the photovoltaic modules.

**Table 11**

| The physical location information of the photovoltaic module | The second electrical location information of the photovoltaic device |
|---|---|
| 1-1 | N1-P1-C1 |
| 1-1 | N1-P1-C2 |
| 1-1 | N1-P1-C3 |
| 1-2 | N1-P1-C4 |
| 1-2 | N1-P1-C5 |
| 1-2 | N1-P1-C6 |
| 2-1 | N1-P2-C6 |
| 2-1 | N1-P2-C5 |
| 2-1 | N1-P2-C4 |
| 2-2 | N1-P2-C3 |
| 2-2 | N1-P2-C2 |
| 2-2 | N1-P2-C1 |

**Table 12**

| | | | | | |
|---|---|---|---|---|---|
| XXXXXX01 | XXXXXX02 | XXXXXX03 | XXXXXX04 | XXXXXX05 | XXXXXX06 |
| XXXXXX07 | XXXXXX08 | XXXXXX09 | XXXXXX10 | XXXXXX11 | XXXXXX12 |

Furthermore, in some embodiments, the layout diagram may also include the second electrical location information of the photovoltaic devices to which the photovoltaic modules are connected.

Specifically, referring to FIG. 13, generating the layout diagram of the photovoltaic power generation system based on the mapping relationship, the device information, and the physical location information may further include step 1301 and step 1302.

Step 1301 may include determining, in a layout diagram template based on the mapping relationship and the physical location information, at least one virtual unit corresponding to each of the plurality of photovoltaic devices. One virtual unit may correspond to one photovoltaic module.

Step 1302 may include binding the device information and the second electrical location information of each of the plurality of photovoltaic devices to the at least one virtual unit corresponding to the corresponding photovoltaic device in the layout diagram template, to generate the layout diagram of the photovoltaic power generation system.

On the basis that the device information of the photovoltaic device is bound to the virtual unit, the second electrical location information may also be bound to the virtual unit.

In an exemplary embodiment, based on the layout diagram of Table 3 generated according to Table 1 and Table 2, the second electrical location information in Table 2 may be bound with the corresponding virtual unit to generate the layout diagram as shown in Table 13. For example, the photovoltaic module with the physical location information 1-1 may correspond to the photovoltaic device N1-P1-C1. At least one virtual unit corresponding to each of the photovoltaic devices in the layout diagram template may be determined based on the mapping relationship. For example, there is a mapping relationship between the photovoltaic device N1-P1-C1 and the photovoltaic module with the physical location information 1-1, so it may be determined that the photovoltaic device N1-P1-C1 is corresponding to the cell 1-1 in the layout diagram template. The device information of the photovoltaic device N1-P1-C1 may be XXXXXX01. The device information of the photovoltaic device N1-P1-C1 may be filled into the cell 1-1 in the layout diagram template, and "N1-P1-C1" may be associated with this cell. The second electrical location information may be directly displayed in the corresponding cell or hidden in the corresponding cell, and the corresponding second electrical location information may be displayed when the cell is selected. The same binding operation for other photovoltaic devices may be performed to generate the layout diagram referring to Table 13.

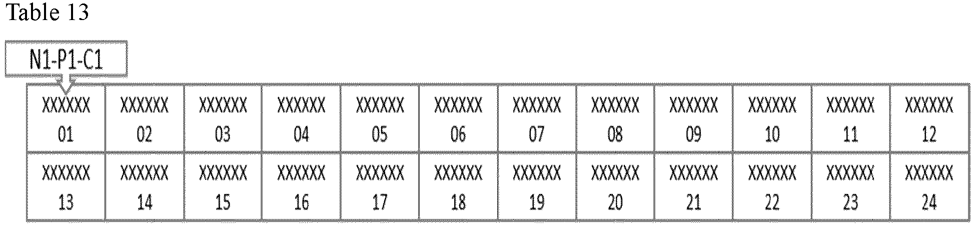

Furthermore, in order to facilitate identification, the photovoltaic modules connected to different photovoltaic device groups may be marked with different colors in the layout diagram, and the photovoltaic modules connected to the same photovoltaic device group may be marked with the same color.

In an embodiment, the device information and the first electrical location information of each of the photovoltaic devices may be acquired manually in step 601. By manually acquiring the device information and the first electrical location information of each of the photovoltaic devices, the positioning of the photovoltaic devices may be realized quickly and conveniently.

In another embodiment, at step 601, the device information and the first electrical location information of each of the photovoltaic devices may be acquired based on communication with a management module in the photovoltaic power generation system. The management module may obtain the device information and the first electrical location information of each of the photovoltaic devices based on communication with each of the photovoltaic devices.

In the present embodiment, the management module may obtain the device information and the first electrical location information of each of the photovoltaic devices based on the communication with each of the photovoltaic devices, which saves labor, and has higher efficiency and accuracy in obtaining information.

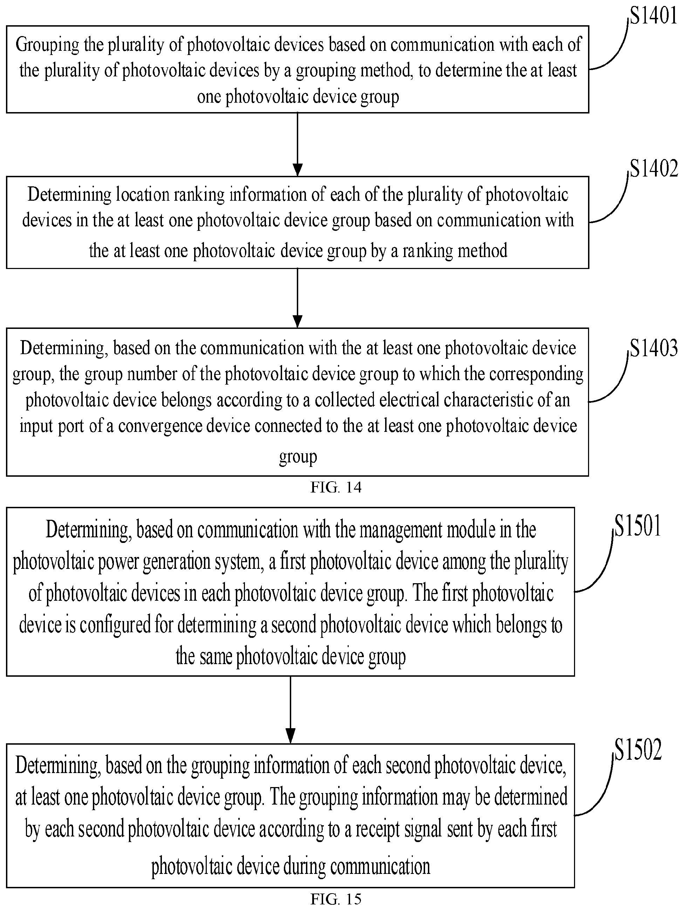

Specifically, referring to FIG. 14, obtaining the device information and the first electrical location information of each of the photovoltaic devices based on the communication with each of the photovoltaic devices by the management module, may further include the following step 1401 to step 1403.

Step 1401 may include grouping the plurality of photovoltaic devices based on communication with each of the plurality of photovoltaic devices by a grouping method, to determine the at least one photovoltaic device group.

Step 1402 may include determining location ranking information of each of the plurality of photovoltaic devices in the at least one photovoltaic device group based on communication with the at least one photovoltaic device group by a ranking method.

Step 1403 may include determining, based on the communication with the at least one photovoltaic device group, the group number of the photovoltaic device group to which the corresponding photovoltaic device belongs according to a collected electrical characteristic of an input port of a convergence device connected to the at least one photovoltaic device group.

**In** the present embodiment, the photovoltaic devices may be grouped based on the grouping method to determine at least one photovoltaic device group, the position ranking information of each of the photovoltaic devices in each photovoltaic device group may be determined based on the ranking method, and the group number of the photovoltaic device group to which the corresponding photovoltaic device belongs may be determined based on the communication between the at least one photovoltaic device group and the management module, according to the collected electrical characteristic of the input port of the convergence device connected to the at least one photovoltaic device group, so that the first electrical location information of each of the photovoltaic devices in the photovoltaic power generation system may be automatically obtained, the positioning of the photovoltaic devices may be quickly and accurately realized, the labor may be saved, and the efficiency is improved.

In an embodiment, referring to FIG. 15, at step 1401, grouping the plurality of photovoltaic devices based on communication with each of the plurality of photovoltaic devices by the grouping method, to determine the at least one photovoltaic device group may further include the following step 1501 and step 1502.

Step 1501 may include determining, based on communication with the management module in the photovoltaic power generation system, a first photovoltaic device among the plurality of photovoltaic devices in each photovoltaic device group. The first photovoltaic device is configured for determining a second photovoltaic device which belongs to the same photovoltaic device group.

Step 1502 may include determining, based on the grouping information of each second photovoltaic device, at least one photovoltaic device group. The grouping information may be determined by each second photovoltaic device according to a receipt signal sent by each first photovoltaic device during communication.

The first photovoltaic device is configured for determining the second photovoltaic device which belongs to the same photovoltaic device group. The first photovoltaic device may be any photovoltaic device in each photovoltaic device group, such as the first photovoltaic device in a photovoltaic device group that communicates with the management module. The second photovoltaic device may be a photovoltaic device with existing grouping information and not the first photovoltaic device.

Since photovoltaic devices are connected by power lines, a signal characteristic of a first receipt signal received by the photovoltaic devices located in the same photovoltaic device group as the first photovoltaic device may be different from that received by the photovoltaic devices located in a different photovoltaic device group as the first photovoltaic device, so the grouping information may be generated according to the signal characteristic. The signal characteristic may include at least one of signal strength, signal attenuation, or signal impedance. Exemplarily, the signal strength of the first receipt signal received by the photovoltaic devices located in the same photovoltaic device group as the first photovoltaic device may be greater than that received by the photovoltaic devices located in a different photovoltaic device group as the first photovoltaic device, so the grouping information may be generated according to the signal strength.

Specifically, the management module may send a competitive-response instruction to all photovoltaic devices. After receiving the competitive-response instruction and completing a random delay, all photovoltaic devices that have not been grouped may detect whether a channel is idle. If yes, a corresponding photovoltaic device may reply to the competitive-response instruction, and the corresponding photovoltaic device may successfully competitively respond. If no, the corresponding photovoltaic device may not reply to the competitive-response instruction, and the corresponding photovoltaic device may fail to competitively respond. After competitive response of the first photovoltaic device is completed, the management module may send a search instruction for the first photovoltaic device, and the photovoltaic device that successfully competitively responds to the competitive-response instruction for the first photovoltaic device may competitively respond to the search instruction for the first photovoltaic device, and the first receipt signal of the response may include the device information of the photovoltaic device. After receiving the first receipt signal, the management module may identify the photovoltaic device as the first photovoltaic device of a certain photovoltaic device group and send a registration instruction for the first photovoltaic device to inform that the photovoltaic device is registered as the first photovoltaic device.

The registration instruction for the first photovoltaic device may also inform the second photovoltaic device to determine its own grouping information, i.e., to determine whether itself is in the same photovoltaic device group as the first photovoltaic device. When the signal strength of the first receipt signal received by a second photovoltaic device is greater than a set threshold, the second photovoltaic device may consider itself to be in the same photovoltaic device group as the first photovoltaic device that sent the first receipt signal. Alternatively, when the first signal strength of the receipt signal received by a second photovoltaic device is greater than the set threshold, the second photovoltaic device may sort the difference between the signal strength of the first receipt signal sent by each first photovoltaic device and the set threshold, and select the first photovoltaic device with the largest difference as the same photovoltaic device group, which may further improve the accuracy of grouping information.

Then, for example, the management module may send a reporting instruction for grouping information in the form of broadcast sequentially, which may instruct all the second photovoltaic devices to report the grouping information and the device information thereof. Alternatively, the reporting instruction for grouping information may include device information of a designated second photovoltaic device, which is configured to instruct the corresponding second photovoltaic device to report the grouping information thereof. Then, the management module may determine all photovoltaic devices in the same photovoltaic device group according to the received grouping information.

Alternatively, for example, the management module may send a search instruction for the second photovoltaic device in the form of broadcast, the search instruction for the second photovoltaic device may include the device information of the first photovoltaic device, and only the second photovoltaic devices which are unregistered and located in the same photovoltaic device group as the first photovoltaic device may participate in the competitive response. At this time, a search range for the second photovoltaic device may be reduced to a photovoltaic device group, which greatly reduces the search range and improves search efficiency for the second photovoltaic device. Then, the second photovoltaic device that successfully competitively respond may send device information to the management module, and the management module may determine all the second photovoltaic devices in the same photovoltaic device group as the first photovoltaic device according to the received device information.

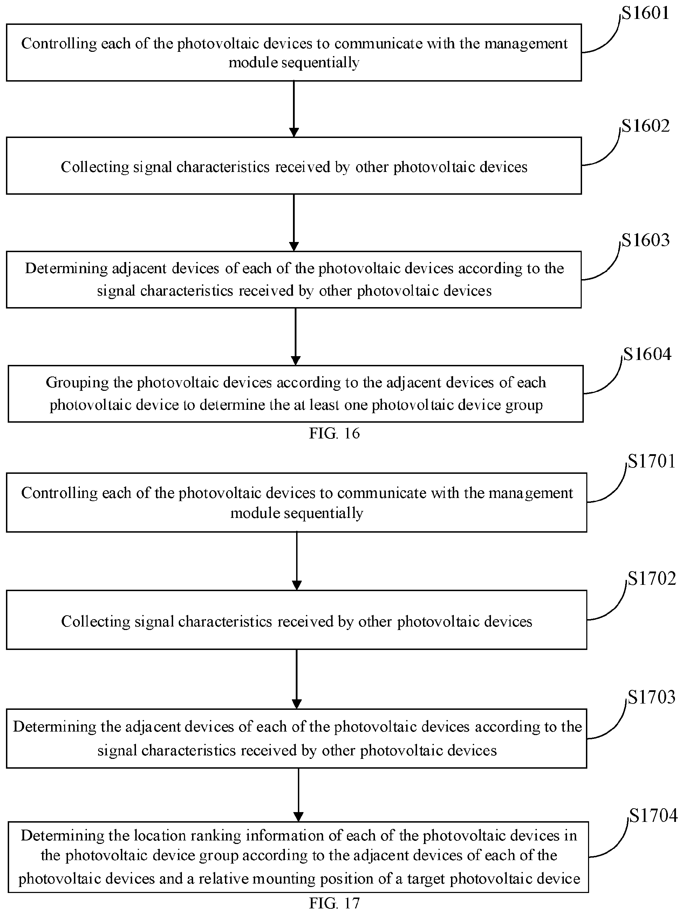

In another embodiment, referring to FIG. 16, at step 1401, grouping the plurality of photovoltaic devices based on communication with each of the plurality of photovoltaic devices by the grouping method, to determine the at least one photovoltaic device group may further include the following step 1601 to step 1604.

Step 1601 may include controlling each of the photovoltaic devices to communicate with the management module sequentially.

Step 1602 may include collecting signal characteristics received by other photovoltaic devices.

Step 1603 may include determining adjacent devices of each of the photovoltaic devices according to the signal characteristics received by other photovoltaic devices.

Step 1604 may include grouping the photovoltaic devices according to the adjacent devices of each photovoltaic device to determine the at least one photovoltaic device group.

Specifically, the management module may communicate with each of the photovoltaic devices sequentially, and the photovoltaic devices here may communicate sequentially according to the sequence of the obtained product sequence numbers of the photovoltaic devices. For example, the management module may send a communication request to the first photovoltaic device, and the first photovoltaic device may send information to the management module after receiving the communication request. At this time, other photovoltaic devices may store the signal characteristic of the received information during communication between the first photovoltaic device and the management module. Similarly, when the management module sends a communication request to a N-th photovoltaic device, N is defined as the total number of the photovoltaic devices, the N-th photovoltaic device may send information to the management module after receiving the communication request. At this time, other photovoltaic devices may store the signal characteristic of the received information during communication between the N-th photovoltaic device the management module. When the photovoltaic power generation system includes N photovoltaic devices, each of the photovoltaic devices may store N-1 signal characteristics, and may store a communication identifier of the corresponding photovoltaic device.

Furthermore, the management module may collect the signal characteristics stored by each of the photovoltaic devices when other photovoltaic devices communicate with the management module by sending a location request to each photovoltaic device, i.e., obtain the signal characteristic information of each of the photovoltaic devices. Specifically, the signal feature information may include the device information of the current photovoltaic device and the signal characteristics of other photovoltaic devices when communicating with the management module. For each of the photovoltaic devices, first, two photovoltaic devices with the strongest signal characteristics may be determined from the signal characteristics of other photovoltaic devices, i.e., the adjacent photovoltaic devices of the photovoltaic device.

Then, the number of photovoltaic device groups and the photovoltaic device groups to which each photovoltaic device belongs may be determined by grouping according to the adjacent photovoltaic devices of each of the photovoltaic devices. Specifically, the first photovoltaic device, such as a photovoltaic device 1, may be randomly selected, and the adjacent photovoltaic devices of the photovoltaic device 1 may be determined as 2 or 2 and 3 according to the signal characteristic information of other photovoltaic devices, then the adjacent photovoltaic devices of the photovoltaic device 2 or the photovoltaic devices 2 and 3 may be determined according to the signal characteristic information of the photovoltaic device 2 or the photovoltaic devices 2 and 3 and the signal characteristic information of photovoltaic devices other than the photovoltaic device 1 and the photovoltaic device 2 or the photovoltaic devices 2 and 3, and adjacent photovoltaic devices of the adjacent photovoltaic devices of the photovoltaic device 2 or the photovoltaic devices 2 and 3 may be determined. At the same time, the determined photovoltaic devices may be merged into a set corresponding to a photovoltaic device group, until the last photovoltaic device has no adjacent photovoltaic device or the adjacent photovoltaic device of the last photovoltaic device is a photovoltaic device in the set, and the determined photovoltaic devices in the set may be determined as photovoltaic devices in a photovoltaic device group. Then, the above process may continue to be performed according to the signal characteristic information of the remaining photovoltaic devices, and the photovoltaic devices in the second photovoltaic device group may be determined until all photovoltaic device groups included in the photovoltaic power generation system are determined.

In an embodiment, referring to FIG. 17, at step 1402, determining location ranking information of each of the plurality of photovoltaic devices in the at least one photovoltaic device group based on communication with the at least one photovoltaic device group by the ranking method may further include the following step 1701 and step 1704.

Step 1701 may include controlling each of the photovoltaic devices to communicate with the management module sequentially.

Step 1702 may include collecting signal characteristics received by other photovoltaic devices.

Step 1703 may include determining the adjacent devices of each of the photovoltaic devices according to the signal characteristics received by other photovoltaic devices.

Step 1704 may include determining the location ranking information of each of the photovoltaic devices in the photovoltaic device group according to the adjacent devices of each of the photovoltaic devices and a relative mounting position of a target photovoltaic device.

In the present embodiment, for each of the photovoltaic devices in the photovoltaic device group, two photovoltaic devices with the strongest signal characteristics may be determined from other photovoltaic devices, i.e., the adjacent photovoltaic devices of the photovoltaic device. Then, the photovoltaic devices in the photovoltaic device group may be ranked according to adjacent photovoltaic devices of each of the photovoltaic devices, and the location ranking information of each of the photovoltaic devices in the photovoltaic device group may be determined combined with the relative mounting position of the target photovoltaic device.

Specifically, an order of all the photovoltaic devices may be obtained by ranking according to adjacent photovoltaic devices of each of the photovoltaic devices: the first photovoltaic device, the second photovoltaic device, ... the N-th photovoltaic device, but it is uncertain whether the order is from the positive electrode to the negative electrode of the photovoltaic device group or from the negative electrode to the positive electrode of the photovoltaic device group. Therefore, the management module may communicate with the target photovoltaic device in the photovoltaic device group under a first condition, and the first condition may be to turn off an input switch of the inverter/the convergence box, turn off the positive pole of the photovoltaic device group or turn off the negative pole of the photovoltaic device group. The management module may determine the relative mounting position information of the target photovoltaic device according to the received signal characteristic of the target photovoltaic device. Alternatively, the management module may determine the relative mounting position of the target photovoltaic device according to the signal characteristic of the target photovoltaic device received before the first condition is executed and the signal characteristic of the target photovoltaic device received after the first condition is executed. Then, the location ranking information of each of the photovoltaic devices in the photovoltaic device group may be determined according to the order of all photovoltaic devices combined with the relative mounting position of the target photovoltaic device.

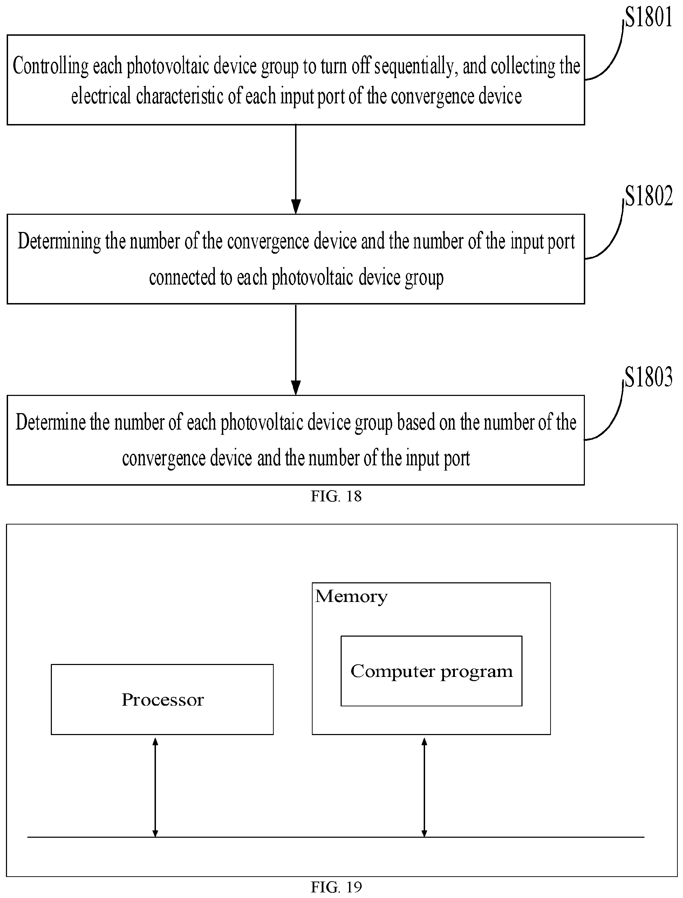

**In** an embodiment, referring to FIG. 18, at step 1403, determining, based on the communication with the at least one photovoltaic device group, the group number of the photovoltaic device group to which the corresponding photovoltaic device belongs according to a collected electrical characteristic of an input port of a convergence device connected to the at least one photovoltaic device group may further include the following step 1801 to step 1803.

Step 1801 may include controlling each photovoltaic device group to turn off sequentially, and collecting the electrical characteristic of each input port of the convergence device.

Step 1802 may include determining the number of the convergence device and the number of the input port connected to each photovoltaic device group.

Step 1803 may include determine the number of each photovoltaic device group based on the number of the convergence device and the number of the input port.

Specifically, the management module may control the photovoltaic device group to turn off, and turn off one photovoltaic device in the photovoltaic device group or turn off a plurality of photovoltaic devices. For example, the photovoltaic device may be a shutdown device, an optimizer or a micro inverter with a quick turn-off function, and the convergence device may be an inverter or a convergence box. After controlling the photovoltaic device group to turn off, the output current and output power of the photovoltaic device group have changed, and correspondingly, the input current and power of the input port of the inverter/convergence box connected to the photovoltaic device group have also changed. Therefore, the input current and/or power of each input port of all inverters/convergence boxes may be collected, and the number of the inverter/convergence box connected to the photovoltaic device group and the number of the input port of the inverter/convergence box may be determined according to the collected input current and/or power. Then, since an input port of an inverter/convergence box is connected to a photovoltaic device group, the number of the corresponding photovoltaic device group may be determined based on the number of the inverter/ convergence box and the number of the input port of the inverter/convergence box.

It should be noted that the grouping method, the ranking method and a group number determining method in the above embodiments may be freely combined to realize the acquisition of the first electrical location information of each of the photovoltaic devices.

It should be understood that although the steps in the above flowchart are displayed in sequence as indicated by arrows, these steps are not necessarily executed in sequence as indicated by arrows. Unless explicitly stated in this article, the execution of these steps is not strictly limited in order, and these steps can be executed in other orders. Moreover, at least some steps in the above flowchart may include multiple steps or multiple stages, which may not necessarily be completed at the same time, but may be executed at different times, and the execution order of these steps or stages may not necessarily be sequentially executed, but may be alternatively executed with other steps or at least a part of steps or stages in other steps.

In an embodiment, referring to FIG. 19, a layout diagram generation apparatus is provided in an embodiment of the present invention, which is applied to a photovoltaic power generation system. The photovoltaic power generation system includes at least one photovoltaic module and at least one photovoltaic device group, the at least one photovoltaic module includes a plurality of photovoltaic cell strings, the at least one photovoltaic device group includes a plurality of photovoltaic devices connected to at least one of the plurality of photovoltaic cell strings respectively, the apparatus includes a memory and a processor, the memory stores a computer program, and the processor is configured to execute the computer program to perform the steps in any of the above-mentioned embodiments of the layout diagram generation method for the photovoltaic power generation system.

The specific definition of the layout diagram generation apparatus may refer to the definition of the layout diagram generation method above, which is not repeated here. The above layout generating apparatus may be realized in whole or in part by software, hardware and combinations thereof.

In an embodiment, a layout diagram generation system is provided in an embodiment of the present invention. A layout diagram generation system includes at least one photovoltaic module, at least one photovoltaic device group, and the layout diagram generation apparatus of the second aspect. The at least one photovoltaic module includes a plurality of photovoltaic cell strings, and the at least one photovoltaic device group includes a plurality of photovoltaic devices connected to at least one of the plurality of photovoltaic cell strings respectively.

The specific definition of the layout diagram generation system may refer to the definition of the layout diagram generation method above, which is not repeated here.

In an embodiment, a computer-readable storage medium is provided in an embodiment of the present invention. The computer-readable storage medium stores a computer program, and the computer program is executed by a processor to perform the steps in any of the above-mentioned embodiments of the layout diagram generation method.

One skilled in the art may understand that implementing all or part of the processes in the above embodiments may be accomplished by instructing relevant hardware through the computer program. The computer program may be stored in a non-volatile computer-readable storage medium, and when the computer program is executed, it can include the processes of the embodiments of the above methods. Any reference to the memory, the storage medium, the database or other medium used in the embodiments provided in this invention may include at least one of a non-volatile memory or a volatile memory. The non-volatile memory may include a Read Only Memory (ROM), a magnetic tape, a floppy disk, a flash memory, or an optical storage. The volatile memory may include a Random Access Memory (RAM) or an external cache memory. As an illustration and not a limitation, the RAM may take various forms, such as a Static Random Access Memory (SRAM) or a Dynamic Random Access Memory (DRAM), etc.

The various technical features of the above embodiments may be combined arbitrarily, and all possible combinations of the various technical features of the above-described embodiments have not been described for the sake of conciseness of description. However, as long as there is no contradiction in the combinations of these technical features, they should be considered to be within the scope of the present description.

The above-described embodiments express only several embodiments of the present invention, which are described in a more specific and detailed manner, but are not to be construed as a limitation on the scope of the present invention. For the skill in the art, several deformations and improvements can be made without departing from the conception of the present invention, all of which fall within the scope of protection of the present invention. Therefore, the scope of protection of the present invention shall be subject to the attached claims.

## Claims

1. A layout diagram generation method for a photovoltaic power generation system, applied to the photovoltaic power generation system, wherein the photovoltaic power generation system comprises at least one photovoltaic module and at least one photovoltaic device group, the at least one photovoltaic module comprises a plurality of photovoltaic cell strings, the at least one photovoltaic device group comprises a plurality of photovoltaic devices connected to at least one of the plurality of photovoltaic cell strings respectively, **characterized in that** the method comprises:
acquiring device information and first electrical location information of each of the plurality of photovoltaic devices, wherein the first electrical location information comprises a group number of a photovoltaic device group to which a corresponding photovoltaic device belongs and location ranking information of the photovoltaic device in the photovoltaic device group to which the photovoltaic device belongs;
acquiring physical location information of the at least one photovoltaic module and second electrical location information of a photovoltaic device connected to the at least one photovoltaic module, wherein the second electrical location information comprises a group number of a photovoltaic device group to which the photovoltaic device belongs and location ranking information of the photovoltaic device in the photovoltaic device group to which the photovoltaic device belongs; and
generating a layout diagram of the photovoltaic power generation system based on the first electrical location information, the second electrical location information, the device information, and the physical location information.

2. The method of claim 1, wherein generating the layout diagram of the photovoltaic power generation system based on the first electrical location information, the second electrical location information, the device information, and the physical location information further comprises:
acquiring a mapping relationship between device information of each of the plurality of photovoltaic devices and physical location information of the at least one photovoltaic module based on correspondence between the first electrical location information and the second electrical location information; and
generating the layout diagram of the photovoltaic power generation system based on the mapping relationship, the device information, and the physical location information.

3. The method of claim 2, wherein generating the layout diagram of the photovoltaic power generation system based on the mapping relationship, the device information, and the physical location information further comprises:
determining, in a layout diagram template based on the mapping relationship and the physical location information, at least one virtual unit corresponding to each of the plurality of photovoltaic devices, wherein one virtual unit corresponds to one photovoltaic module; and
binding the device information of each of the plurality of photovoltaic devices to the at least one virtual unit corresponding to the corresponding photovoltaic device in the layout diagram template, to generate the layout diagram of the photovoltaic power generation system.

4. The method of claim 2, wherein generating the layout diagram of the photovoltaic power generation system based on the mapping relationship, the device information, and the physical location information further comprises:
determining, in a layout diagram template based on the mapping relationship and the physical location information, at least one virtual unit corresponding to each of the plurality of photovoltaic devices, wherein one virtual unit corresponds to one photovoltaic module; and
binding the device information and the second electrical location information of each of the plurality of photovoltaic devices to the at least one virtual unit corresponding to the corresponding photovoltaic device in the layout diagram template, to generate the layout diagram of the photovoltaic power generation system.

5. The method of claim **1,** wherein while acquiring physical location information of the at least one photovoltaic module and second electrical location information of the photovoltaic device connected to each of the at least one photovoltaic module, the method comprises further acquiring connection information of the at least one photovoltaic module, wherein the connection information comprises connection information between the at least one photovoltaic module and a port of a photovoltaic device corresponding to the photovoltaic module; and
generating the layout diagram of the photovoltaic power generation system based on the first electrical location information, the second electrical location information, the device information, the physical location information, and the connection information.

6. The method of claim 1, wherein acquiring physical location information of the at least one photovoltaic module and second electrical location information of the photovoltaic device connected to the at least one photovoltaic module further comprises:
acquiring, based on a design drawing of the photovoltaic power generation system, physical location information of the at least one photovoltaic module and second electrical location information of the photovoltaic device connected to the at least one photovoltaic module.

7. The method of claim 1, wherein acquiring device information and first electrical location information of each of the plurality of photovoltaic devices further comprises:
acquiring, based on communication with a management module in the photovoltaic power generation system, device information and first electrical location information of each of the plurality of photovoltaic devices, wherein the management module obtains device information and first electrical location information of each of the plurality of photovoltaic devices based on communication with each of the plurality of photovoltaic devices.

8. The method of claim 7, wherein the management module obtaining device information and first electrical location information of each of the plurality of photovoltaic devices based on communication with each of the plurality of photovoltaic devices further comprises:
grouping the plurality of photovoltaic devices based on communication with each of the plurality of photovoltaic devices by a grouping method, to determine the at least one photovoltaic device group; and
determining location ranking information of each of the plurality of photovoltaic devices in the at least one photovoltaic device group based on communication with the at least one photovoltaic device group by a ranking method; and
determining, based on the communication with the at least one photovoltaic device group, the group number of the photovoltaic device group to which the corresponding photovoltaic device belongs according to a collected electrical characteristic of an input port of a convergence device connected to the at least one photovoltaic device group.

9. A layout diagram generation apparatus, applied to a photovoltaic power generation system, wherein the photovoltaic power generation system comprises at least one photovoltaic module and at least one photovoltaic device group, the at least one photovoltaic module comprises a plurality of photovoltaic cell strings, the at least one photovoltaic device group comprises a plurality of photovoltaic devices connected to at least one of the plurality of photovoltaic cell strings respectively, the apparatus comprises a memory and a processor, the memory stores a computer program, and the processor is configured to execute the computer program to perform the method of any one of claims 1 to 8.

10. A layout diagram generation system, comprising at least one photovoltaic module, at least one photovoltaic device group, and the layout diagram generation apparatus of claim 9, wherein the at least one photovoltaic module comprises a plurality of photovoltaic cell strings, and the at least one photovoltaic device group comprises a plurality of photovoltaic devices connected to at least one of the plurality of photovoltaic cell strings respectively.

11. A computer-readable storage medium, storing a computer program, wherein the computer program is executed by a processor to perform the method of any one of claims 1 to 8.
